# EUROPEAN PATENT APPLICATION

(11) **EP 2 330 624 A1**
(43) Date of publication of application: **08.06.2011**
(21) Application number: 09252711.8
(22) Date of filing: 01.12.2009
(51) Int. Cl.: H01L 27/02

(54) **Well structure for body biasing, manufacturing and design method**

(71) Applicant: NXP B.V., 5656 AG Eindhoven (NL)
(72) Inventor: Meijer, Rinze Ida Mechtildis Peter , NXP Semiconductors, Redhill, Surrey RH1 1DL (GB); Pineda de Gyvez, Jose de Jesus , NXP Semiconducttors, Redhill, Surrey RH1 1DL (GB)
(74) Representative: Ashton, Gareth Mark

(57) **Abstract**

An integrated circuit comprising: a plurality of n-well and p-well regions (305, 306) arranged in alternating parallel rows across a plane of the integrated circuit; a deep n-well region (301) beneath the n-well and p-well regions (305, 306) and extending between first and second n-well region rows (305₁, 305₂) either side of a third n-well region row (305₃); and a plurality of n-well region columns (307) connecting the first and second n-well region rows (305₁, 305₂) and overlaying a portion of a boundary of the deep n-well region (301).

## Description

The invention relates to layouts of body biasing clusters in integrated circuit floor plans.

Applying a bias voltage to the body of a transistor in an integrated circuit alters the transistor threshold voltage and affects its leakage current. Body biasing, which can be in the form of forward or reverse biasing, may therefore be used in integrated circuit designs to reduce leakage or to speed up transistors for meeting timing specifications. In early implementations an entire circuit would be back-biased through application of a bias voltage to the entire substrate. More recent techniques are emerging that allow for multiple back bias voltages to be used more selectively on specific areas of an integrated circuit. This allows far more scope for 'post-silicon' adjustment (i.e. after manufacture), and allows a design to be tuned to meet the required specifications. This technique is particularly important for modern integrated circuits, particularly those having feature sizes of less than 100nm, where uncontrollable process and material variations can increasingly result in a larger proportion of components being initially outside a desired specification.

References [1-5] illustrate examples where a synthesized netlist results in the need for more than one body bias voltage. Reference [4] in particular discloses a method of clustering gates at design time into a number of body bias groups, which are then individually tuned post-silicon for each die. One particular layout example shown in figure 15 of this document indicates an arrangement of body bias clusters resulting from this process. This layout is, however, not necessarily optimised for the use of body biasing in a practical way. It is difficult to show from the non-regular nature of the layout how a body biasing routing grid could be implemented in practice.

One method of implementing body biasing in an integrated circuit, described in further detail below, involves the use of deep n-well regions (also known as triple wells). Because these regions are required to be separated to allow for biasing at distinct voltages, providing a layout that does not take this separation into account can result in a non-functioning circuit. The arrangement illustrated in reference [4] therefore shows how it may be theoretically possible to derive a layout of body bias islands, but does not address the problem of how to arrange such a layout in an efficient and practical way.

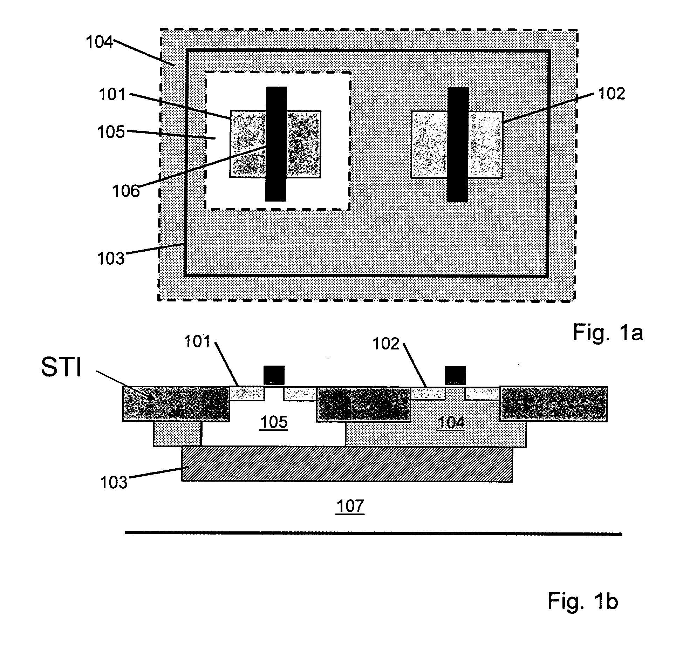

One method of implementing body biasing in both PMOS and NMOS transistors involves introducing an additional n-doped layer beneath a selected area of the transistor layout, the additional layer being known as a triple-well or deep n-well. This ensures that PMOS and NMOS transistors laid over the deep n-well region are isolated from the wafer substrate by the additional layer. Figure 1a illustrates in plan view, and figure 1b in cross-section, an exemplary layout for an NMOS transistor 101 and a PMOS transistor 102 arranged over a deep n-well region 103. The deep n-well region 103 acts to isolate the body contacts of each transistor 101, 102 from the underlying p-doped substrate 107. The PMOS and NMOS transistors are shown within corresponding n- and p-wells 104, 105. Isolating these wells from the substrate 107 using the deep n-well region 103 allows the transistors 101, 102 to be biased to a potential different to that of the substrate 107, thereby allowing for selective body biasing of the transistors 101, 102.

Layout design rules for distinctly biased deep n-wells require a minimum separation between adjacent deep n-well regions. As an example, for a feature size of 65nm the required separation is 350nm. It is the therefore important to consider this separation when designing an optimum layout involving multiple body bias islands (defined by the boundaries of deep n-well regions).

Deriving a layout for an integrated circuit using multiple body biasing islands without taking into account this required separation can therefore result in a non-functional design. If such a separation is taken into account, this can result in a non-optimal design because the required separation between body bias islands uses up space on the layout that may not be available for other purposes.

It is an object of the invention to address one or more of the above mentioned problems.

In accordance with a first aspect of the invention there is provided an integrated circuit comprising:
a plurality of n-well and p-well regions arranged in alternating parallel rows across a plane of the integrated circuit;
a deep n-well region beneath the n-well and p-well regions and extending between first and second n-well region rows either side of a third n-well region row; and
a plurality of n-well region columns connecting the first and second n-well region rows and overlaying a portion of a boundary of the deep n-well region.

An advantage of the invention is that the deep n-well regions, which define areas of independent body biasing, can be more efficiently arranged in standard cell layouts.

The first and second n-well region rows preferably overlay a portion of the boundary of the deep n-well region, and the entire boundary of the deep n-well region further preferably overlaid with n-well regions.

One or more passive components may be provided in cells across the first or second n-well region row and an adjacent p-well region row outside the boundary of the deep n-well region. Incorporating passive components in this way makes more efficient use of the otherwise wasted space that needs to be allowed for around each deep n-well region. The passive components may be capacitors, used for example as decoupling capacitors.

The integrated circuit will generally comprise a plurality of said deep n-well regions, with each deep n-well region separated from an adjacent deep n-well region by a p-well region column.

In accordance with a second aspect of the invention there is provided a method of manufacturing an integrated circuit, the method comprising the steps of:
defining a deep n-well region in a substrate;
defining a plurality of n-well and p-well regions over the deep n-well region, the plurality of n-well and p-well regions being arranged in alternating parallel rows across a plane of the substrate, the deep n-well region extending between first and second n-well region rows either side of a third n-well region row; and
defining a plurality of n-well region columns connecting the first and second n-well region rows and overlaying a portion of the boundary of the deep n-well region.

Optional and preferable features according to the first aspect of the invention may also apply correspondingly to the second aspect of the invention, with corresponding resulting advantages.

In accordance with a third aspect of the invention there is provided a method of designing a layout of an integrated circuit, the method comprising:
defining a plurality of n-well and p-well regions arranged in alternating parallel rows across a plane of the integrated circuit;
arranging a plurality of cells comprising transistors over the plurality of n-well and p-well regions, in which a subset of the plurality of cells is selected to require a common body bias voltage;
defining a deep n-well region beneath a selected area of the n-well and p-well regions, the deep n-well region extending between first and second n-well region rows either side of a third n-well region row;
positioning the subset of the plurality of cells over the deep n-well region; and
defining a plurality of n-well region columns connecting the first and second n-well region rows and overlaying a portion of the boundary of the deep n-well region.

The invention is described in further detail below by way of example and with reference to the accompanying drawings in which:
figures 1 a and 1b are schematic plan and cross-sectional views respectively of an exemplary layout of NMOS and PMOS transistors arranged over a deep n-well region;
figure 2 is a plan view of a portion of an exemplary standard integrated circuit cell layout without a deep n-well region;
figure 3 is a schematic plan view of a layout of a body bias island according to an embodiment of the invention;
figure 4 is a schematic plan view of a layout of a body bias island according to an embodiment of the invention;
figure 5 is a schematic plan view of an exemplary layout of multiple body bias islands according to an embodiment of the invention;
figure 6 is a chart illustrating the distribution of the number of die samples having a given performance;
figure 7 is a chart of distribution of path lengths in a circuit design;
figure 8 is a scatter plot of frequency as a function of current leakage before and after tuning;
figure 9 is a chart illustrating a distribution of body bias voltages used for tuning;
figure 10 is a schematic floorplan of a chip after optimization;
figure 11 is a schematic floorplan of a chip having on-chip slack monitoring;
figure 12 is a block diagram of a voltage threshold controller; and
figure 13 is an overview block diagram of hardware infrastructure for post-silicon tuning.

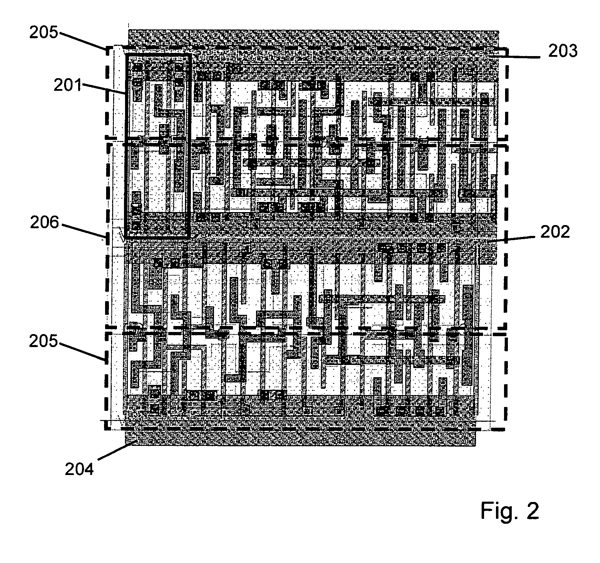

Figure 2 illustrates in plan view a portion of a standard cell layout of an integrated circuit. Each individual cell 201 typically comprises a group of transistors in an arrangement that is configured to perform a particular logic function, for example in the form of an inverter, a NAND gate or an AND gate. For design purposes, such cells are used as repeated patterns in the cell layout. Typical floor plans comprise multiple rows of such standard cells. These rows are mirrored to allow for sharing of gnd and vdd potential lines, i.e. each vdd line is located between two gnd lines, with cells spanning the gnd and vdd lines on each side. The portion shown in figure 2 shows a single vdd line 202 shared by cells located on either side of this line, and two gnd lines 203, 204. Each cell 201 is arranged to extend between adjacent vdd and gnd lines.

Also shown in figure 2 are areas 205, 206 where the transistors are of NMOS and PMOS types respectively, as provided by an underlying nwell or pwell structure.

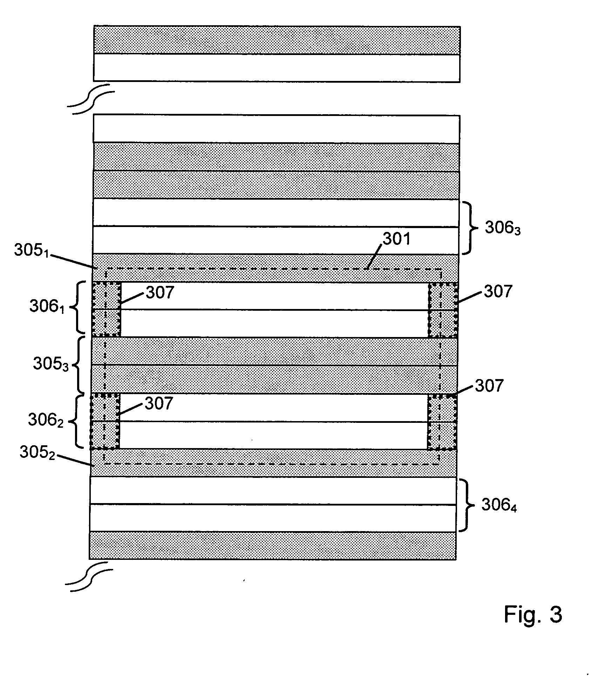

Figure 3 illustrates a schematic plan view of a standard cell layout floor plan incorporating a body bias cluster or island 301, i.e. a region in which the cells are able to be addressed with a common body bias. Shaded areas in figure 3 indicate n-well regions 305, and unshaded regions indicate p-well regions 306. As with the standard cell arrangement shown in figure 2, the n-well regions 305 and p-well regions 306 are generally arranged in alternating rows, with adjacent pairs of n-well and p-well rows constituting placeholders for locating standard cells. These alternating rows are not necessarily of uniform thickness, as shown in figure 3. In the absence of body biasing, n-well regions are connected to the vdd potential, while p-well regions are connected to the gnd potential.

The body bias island 301 is created by providing a deep n-well region beneath a selected area of n-well and p-well regions. The deep n-well region 301, which defines the extent of a body bias cluster, extends between a first n-well region 305₁ and a second n-well region 305₂ either side of a third n-well region row 305₃, with p-well region rows 306₁, 306₂ between consecutive pairs of n-well region rows.

Transistors within n-well and p-well regions that overlay the deep n-well region 301 can be chosen to have body potentials other than vdd and gnd respectively, defined herein as vnw and vpw to distinguish from vdd and gnd. The exemplary layout shown in figure 3 shows the case where only one body bias island is present, and where the island extends over the entire length of a standard cell row. Further body bias islands may be provided in either lateral direction, as described in more detail below.

The row boundaries of each body bias island are delimited by n-well region rows 305₁, 305₂ biased at a body bias voltage vnw, which may be different from vdd. In addition, the column boundaries on either side of the deep n-well region 301 are also delimited by particular cells of a type defined herein as "tying cells" 307. A tying cell 307 is in general a standard cell that is configured to bridge the n-well region rows on either side. Each tying cell 307 may be considered to be an n-well column, with a plurality of such columns extending between the first and second n-well region rows 305₁, 305₂.

Further p-well separation rows 306₃, 306₄ are provided for the required physical separation distance around each body bias island 301. The width of these rows depends upon the technology design rules, which dictate the required separation distance between a deep n-well region 301 and the next n-well region. These separation rows 306₃, 306₄ are biased with the gnd potential to continue with the standard type of floor plan layout.

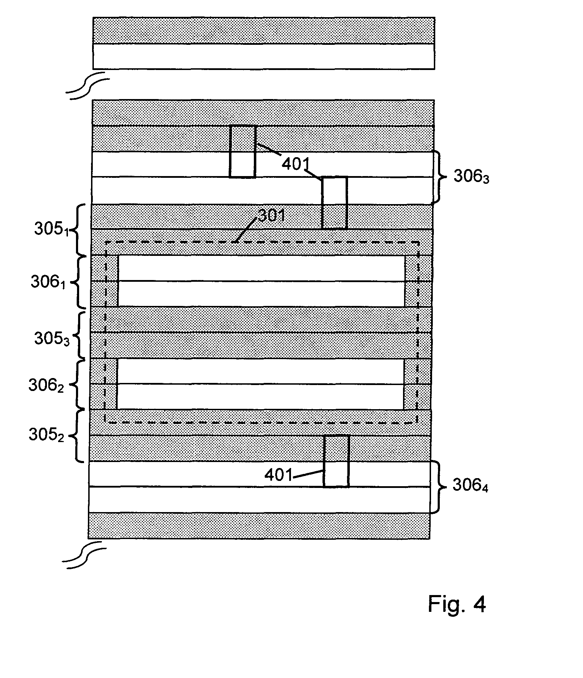

In the embodiment shown in figure 3 the separation rows 306₃, 306₄ are unutilized. In the alternative embodiment shown in figure 4 the separation rows 306₃, 306₄ are instead populated with filler cells or decoupling capacitor cells in special cells 401, the outlines of which are indicated in figure 4. Filler cells are cells that do not have transistors but that are used to provide continuity in the metal lines that carry vdd/gnd and also in the n-wells. The first and second n-well rows 305₁, 305₂ are made wider to allow for the special cells 401 to be incorporated. An advantage of using the otherwise wasted space of the separation rows is that at least some of the passive components that are needed in the integrated circuit can be incorporated more efficiently. Such components do not affect the underlying isolation of the deep n-well structure.

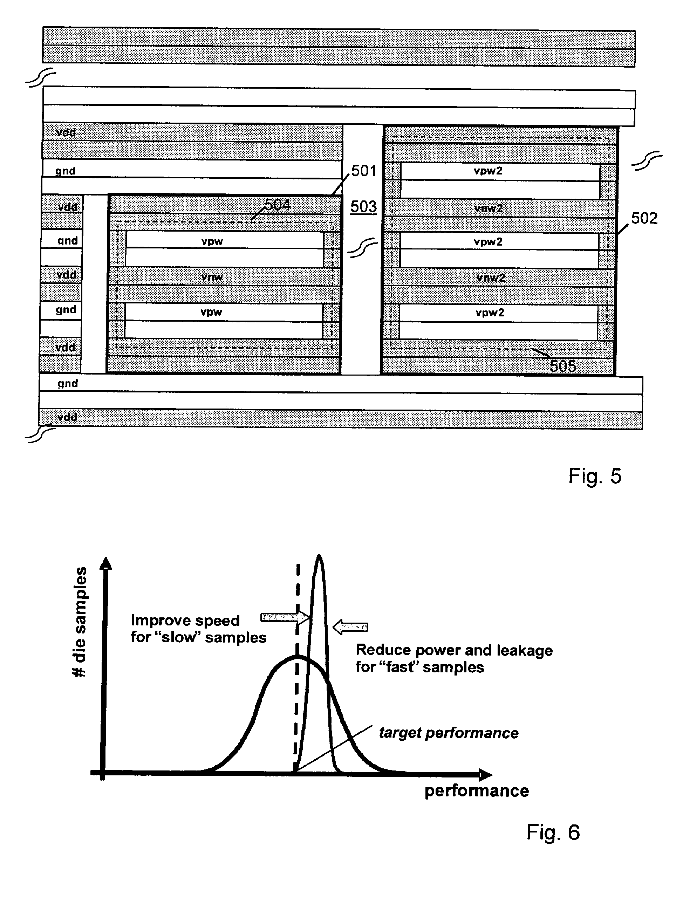

A further embodiment illustrating multiple body bias islands is illustrated in figure 5. In this embodiment, two horizontally adjacent islands 501, 502 of different size are shown, each island 501, 502 comprising a deep n-well region 504, 505. The islands 501, 502 are separated in the direction of the rows by a p-well column 503 and in the direction of columns by p-well separation rows as before. Further body bias islands may be added as required, using further p-well separation rows and columns.

Aspects of the invention may be incorporated in methods of designing integrated circuit layouts, in which a standard cell layout is used comprising a plurality of n-well and p-well regions arranged in alternating parallel rows across a plane of the integrated circuit. A plurality of cells comprising transistors is arranged over the plurality of n-well and p-well regions, and a subset of the plurality of cells is selected to require a common body bias voltage. A deep n-well region is defined beneath the n-well and p-well regions, the deep n-well region extending between first and second n-well region rows either side of a third n-well region row. The subset of the plurality of cells are defined over the deep n-well region, and a plurality of n-well region columns are defined connecting the first and second n-well region rows and overlaying a portion of the boundary of the deep n-well region. The method of designing is typically iterative in nature, as changes to the layout required to assemble cells requiring a similar bias voltage may result in further changes.

In an embodiment of a method of designing an integrated circuit according to the invention, the longest paths may be used to define a subset of cells to which a common body bias voltage is to be applied.

Traditionally, ASIC designers use a worst case design (WCD) approach to guarantee chip performance among the process corners. For such an approach, digital designs are synthesized for worst process-voltage-temperature (PVT) conditions (slow process, V_{DD}-10%, 85°C) to meet timing specifications. The performance of a fabricated IC falls under a normal distribution whose 3σ point is bounded to the worst PVT conditions. Traditionally, it is assumed that this worst-case performance is rigid with respect to the worst-case electrical parameters like the transistor's threshold voltage (Vₜₕ), transconductance, etc. In other words, if the IC is fabricated under worst-case electrical parameters it is assumed that the performance is likely to be worst-case. Hence, designers use the worst-case process corner to guarantee a circuit performance target. However, transistor body biasing (BB) and voltage scaling (VS) can be used at run-time to tune the electrical parameters of selected transistors after IC fabrication. For instance, it is possible to increase or decrease the Vₜₕ during normal operation to impact the performance of the entire IC and thus, correct its performance when it is out of spec due to manufacturing variations.

Statistical methods may be used to optimize circuit performance and power by properly choosing values of Vₜₕ and V_{DD}, among other parameters, as disclosed in references [1,2]. Furthermore, these optimization methods can also be used to minimise core sizes. All these methods are applied at design time, i.e. prior to circuit fabrication. While the resulting circuit may be optimal for performance/power specs as well as being more robust, these design methods may not be able to prevent circuit malfunctioning in the presence of severe manufacturing variations.

Recent studies disclose techniques for pre-silicon and post-silicon co-optimization [3,4]. The proposed technique of reference [3] optimizes gate sizing statistically under the assumption that body bias is present in run-time to adjust leakage specification deviations due to manufacturing variations. This approach results in body bias voltages over the entire chip. However, the optimization targets leakage minimization. In reference [4], optimization is achieved by generating multiple body biasing clusters based on a correlation factor that depends on cell proximity, as well on a matching score of theoretical body biasing probability distribution functions. The approach described herein also uses body bias clusters, but is able to operate on a smaller subset of cells of the entire circuit. In reference [5] a post-silicon tuning is carried out to show that that body biasing can improve chip yield through local adaptation of the well potentials. This tuning is based on a gradient approach to adapt the body bias voltages. This paper does not discuss the partitioning of the circuit into clusters for optimal biasing. For large chips this could be counterproductive if one takes into account the hardware infrastructure that is needed to supply the correct body bias voltage. In the alternative approach herein, optimum partitioning and voltages are defined at design time, thereby providing a saving in this form of test time and overhead cost in tuning the circuit.

The design method described herein also solves the problem of reduced chip performance and chip yield loss due to process variability. A key difference compared with previously published materials is that optimising the entire circuit for leakage is not required. Rather, a subset of cells is optimized to improve circuit slack. In particular, the slack of the longest paths in the circuit is optimized to either compensate for loss of performance or to boost circuit speed. This pre-silicon optimization is applied to the subset of cells that constitute the longest paths of the design, as opposed to the entire circuit as in previous approaches. This optimization results in clusters of cells with distinct body bias voltages, where the clusters are in the form as described above. Once this optimization is carried out, the remaining paths can be optimized for power. Post-silicon, the circuit speed can be evaluated with respect to speed in the typical process corner and any necessary (scaled) body bias voltages applied to compensate for performance loss. Because the optimization is done on a much smaller set of cells, instead of the whole circuit, this approach translates into a simpler post silicon tuning scheme and into a more effective pre-silicon design optimization. An overview of how this method effects the distribution of manufactured chips is illustrated in figure 6, which illustrates a general relationship between the number of die samples and the chip performance. A normal distribution would generally be expected. A target performance is defined at the mean performance value. This means that many of the dies will fail to reach this target performance. In order to improve the overall spread of performance, the speed of the samples below target can be boosted, and the leakage and power can be reduced for those samples well above the target. Both of these can be achieved through selective body biasing, provided the right selection is made. This has the effect of narrowing the performance spread, and boosting the overall mean performance.

This aspect of the invention can be used to enhance circuit robustness and chip yield by adjusting the propagation of long paths such that their corresponding slack time is increased based upon on-chip adaptation and on-chip process calibration. This approach essentially enhances circuit yield. A second application of this aspect of the invention is to enhance circuit performance by reducing the propagation delay of long paths by a fixed percentage. A third application is to reduce the circuit's power-delay product by increasing slack time in long paths through body biasing, and by adjusting the power supply on the remaining paths.

The invention offers the following advantages:
- On-chip adaptation of long paths through body biasing to enhance circuit speed;
- On-chip adaptation of short and medium length paths through voltage scaling and/or reverse biasing to reduce active power and leakage;
- Body biasing (BB) being applied to only a subset of cells rather than to the whole core, thereby reducing BB hardware overhead;

To achieve one or more of these advantages, body biasing may be applied to long paths of the circuit, and to a subset of cells rather than to the whole circuit. This results in a smaller body biasing hardware infrastructure overhead. On chip tuning can make use of a representative sample of long paths for use as speed monitors to compensate speed loss.

In exemplary embodiments, a pre-silicon optimization is carried out based on the assumption that body biasing is available on-chip. Circuit slack is optimised and body biasing is enabled only for those cells that constitute the longest paths of the design. This is an important feature because variations on the propagation delay of the longest paths can jeopardize circuit performance specs. Medium and short length paths have a far more relaxed timing slack and thus require less attention.

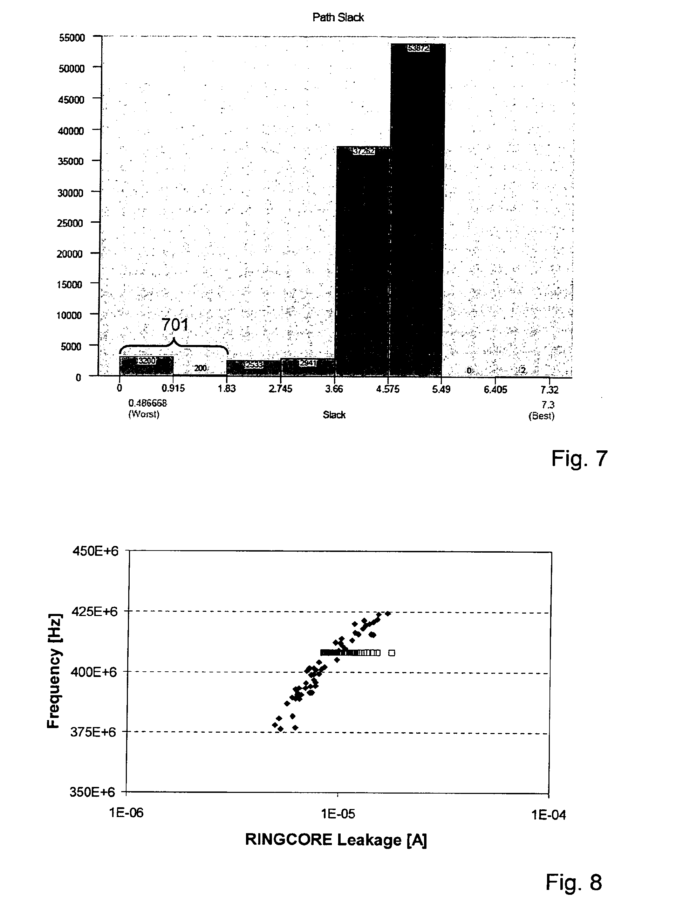

Forward biasing can be used to correct performance loss. Figure 7 illustrates a distribution of path lengths of a typical design. The longest paths 701 are those that need to be optimized to prevent circuit malfunctioning. The proportion of paths to be optimised is typically about 3% of the total number of paths. In a general aspect therefore, the subset of the plurality of cells is selected based on the longest paths in the integrated circuit, where the paths selected are those within the longest 3% of paths in the circuit design.

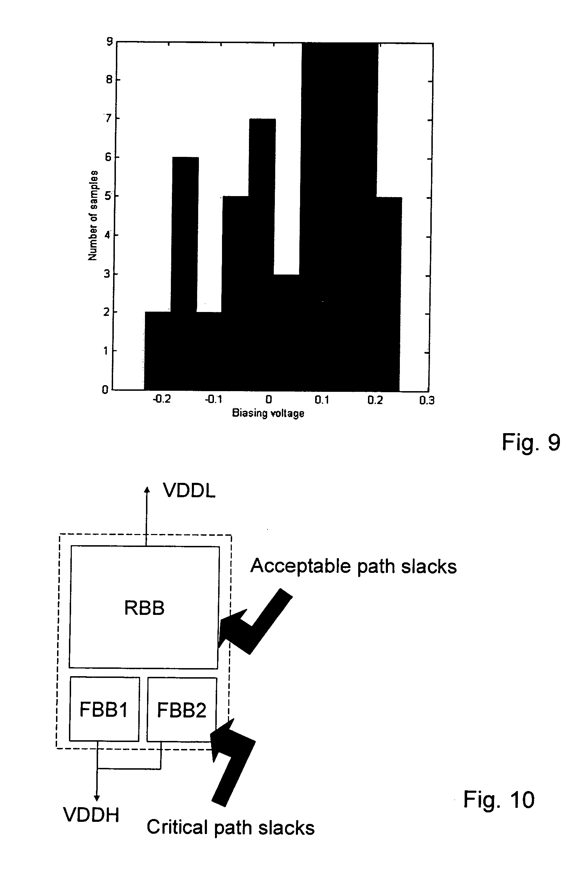

For a CMOS 45nm technology, a maximum forward bias voltage of 0.5V has been found to results in an approximately 25% performance increase. Figure 8 illustrates an example of a result of performance compensation in CMOS 45nm by means of forward and reverse biasing. This figure, plotting frequency as a function of ringcore leakage current, shows the results of 57 IC samples that were "tuned" to meet a desired typical performance of 408MHz. Figure 9 shows the distribution of body bias voltages used to tune these chips, the biasing voltage ranging from - 0.25V to +0.25V.

This aspect of the invention use the possibility of adapting chip behaviour on-line and in real-time by applying forward and reverse body biasing, as well as power supply voltage scaling. The method of design optimisation begins with a synthesized circuit. Synthesis can be carried out for example using the techniques described in references [1,2]. From the synthesized circuit, for example in the form of verilog netlist and timing reports, all paths *pᵢ* are sorted in descending order of length and their propagation delay *T_{¡}* evaluated. Let s = *{Pi}* represent the set of paths in the circuit. For a given clock period *T_{ck}* , we select then all paths for which their slack time, S*ᵢ* = *T_{ck} - T_{¡}*, is in the range *Sᵢ* ≤ *(T_{ck}― aTᵢ*), where a*∈* (*0,* 1] is the slack tuning range factor that depends on the maximum forward body bias voltage that can be applied to the circuit. Let us denote the set of these ordered paths as Ψ. Observe that this path filtering will select the topmost paths of our ordered list, e.g. the longest paths. Let the set of slacks be *ϕ* = *{S*₁ *S*₂ *S*₃ ... *S_{N}}* such that there is a one to one mapping with Ψ, e.g. a bijective mapping *ϕ*↔Ψ. Without loss of generality let the path's propagation delay be calculated as the sum of the propagation cell delay *Dⱼ* of each cell in the path *Pᵢ*, e.g. *Tᵢ =*∑*Dⱼ.* Let *h(·)=Vₜₕ(V_{BB})* be a function representing the dependence of the threshold voltage *Vₜₕ* on body biasing *V_{BB}.* Then, the dependence between cell delay D and body biasing, *V_{BB},* is approximately D *= KV_{DD} (V_{DD} - h(·))^{-α}* where K is process related constant, *V_{DD}* is the power supply voltage, and α is the velocity saturation constant. Let the power of path *Pᵢ* be computed as *Power(pᵢ) = CV²_{DD}*/*Tᵢ + V_{DD}* (*lₒ* 10^{*h(·)*/}*ⁿ)* where n is the subthreshold slope and *lₒ* 10^{*h(·)*/*n*} represents the path's leakage current. Let γ = *{V₁ V₂ V₃* ... *V_{N}}* be the set of available body bias voltages. Then, we carry out a slack optimization subject to tuned path delay, maximum power limit, and available body bias voltages as follows
maximize *Sᵢ* V *Sᵢ* ∈ *ϕ*
subject to *V_{BBi}* ∈ γ γ *={V₁ V₂ V₃* ... *V_{N}}*
*bTᵢ ≤ T_{ck} -Sᵢ ≥ aTᵢ 0 < b ≤ a*
∑*Power(pᵢ)* ≤ κ
where κ is an upper boundary of power. This optimization procedure clusters cells from all paths in Ψ based on body bias voltages in such a way that the slack of each path in the ordered list of paths Ψ is basically increased by a factor a without incurring into hold-time violations which are time bounded to *bT*_{ck} *.* A boundary on this constraint is to have *b ≅ a*. In this case all paths are optimized to have the same slack. Notice that not all cells will have the same body biasing V*_{BBj}*. Those paths whose slack *Sᵢ* ≈ 0 are likely to have cells with the highest body bias voltage, while those paths whose slack *Sᵢ* ≈ *aT_{ck}* are likely to have cells with the lowest body bias voltage. A slight variation on this optimization procedure is to account for power. This can be done by further constraining the optimization to the whole of *Power(pᵢ).*

A clear advantage of this approach is that only a small percentage of all cells are adapted in the entire core, the ones in Ψ, and thus the requirements on the body bias actuator are relaxed. This has implications on static power requirements and area of the actual body bias actuator (EP08105734.1 refers to the making of such actuator). For instance, an actuator that will bias a well which is only, say 10%, of the total well area, will consume roughly 90% less static power.

An alternate optimization is to minimize the cardinality of γ for a given target slack as follows
minimize lγl γ = *{V₁ V₂ V₃*... *V_{N}}*
subject to *bTᵢ* ≤ *T*_{ck} *- Sᵢ > aTᵢ 0* < *b* ≤ *a*
∑*Power(pᵢ)* ≤ *κ* ∀ *pⱼ* ∈ s

The remaining paths in s \ Ψ can further be optimized for leakage or power by adapting the power supply voltage or by applying reverse bias as follows
minimize ∑*Power(pⱼ)* ∀ *pⱼ* ∈ s *\*Ψ
subject to -*\*/*_{BBj}* ∈ *{V₁ V₂ V₃* ... *V_{N}}*
*V_{DDj} E {V_{DD1} V_{DD2} V_{DD3} ... V_{DDN}}*
*Tᵢ* < a*T_{ck}* 0 ≤ a, ∀ *pⱼ* ∈ *s \Ψ*

An exemplary floorplan of a chip after optimization is shown schematically in figure 10. This illustrates the case of two clusters of critical paths which can be corrected by applying independent forward bias voltages FBB1, and FBB2. Also indicated, these clusters are powered from a nominal supply VDDH. The noncritical paths have a supply lower than the nominal supply, e.g. VDDL, with optional reverse body biasing RBB to minimize power consumption.

Once the chip is manufactured, it is necessary to verify its performance to decide whether or not body bias compensation is needed. This verification can be done at test time, or during run-time as part of a cold-start routine. The speed monitor can be based on ring oscillators or on actual circuit-extracted paths for each body bias cluster. The latter approach is preferred.

For slack correction, let us assume that there are N monitors, with N *= min*| *γ*| representing the optimum number of body bias clusters (slack adjustments) found during the pre-silicon optimization stage. The response of each monitor is evaluated against its corresponding design time golden signature, e.g. the expected path delay Tᵢ or some representation of it. If after manufacturing a monitor renders a slack *Sᵢ* ≤ 0, or *T*_{ck} - *Sᵢ* < *aT_{¡}*, the golden forward bias voltage *Vᵢ* ⊂ *γ.* is applied to the corresponding chip paths to correct their slack. If the on-chip body bias actuator offers flexibility to select voltages, a fine tuning may be chosen for each Vᵢ to find perfect matches to the golden signature Tᵢ. The forward bias voltages used to compensate the monitor performance can further be stored on-chip on, say, a non volatile medium at test time. These voltages can later be retrieved during the actual operation of the chip.

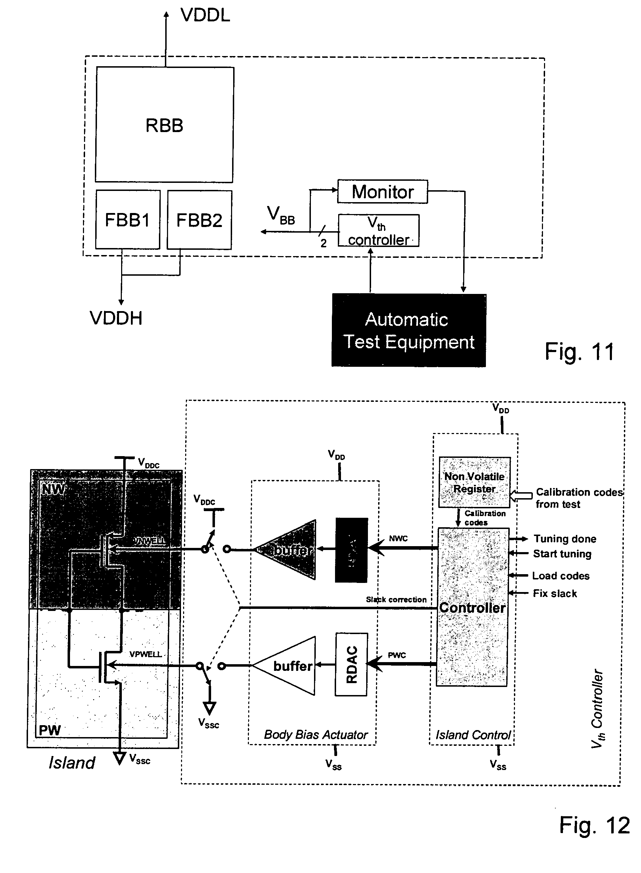

Figure 11 shows the chip diagram of figure 10 with an on-chip slack monitor interacting with automated test equipment to determine the appropriate FBB voltage to correct the slack. The embodiment shows one monitor only, but there may as many monitors as there are FBB clusters. Figure 12 depicts a block diagram of the Vₜₕ controller. The Vₜₕ controller comprises a body bias actuator and an island control. The Vₜₕ controller translates a digital word into an analog voltage for biasing. The code may be stored in non-volatile memory in the controller after calibration.

Alternatively, if no test-time calibration is done, a closed-loop system at run-time can be used to bias the various clusters of the chip.

It is also possible to boost circuit speed by setting each *V_{BBi}* = *max {γ}.* This will effectively scale up all path slacks by a constant factor a

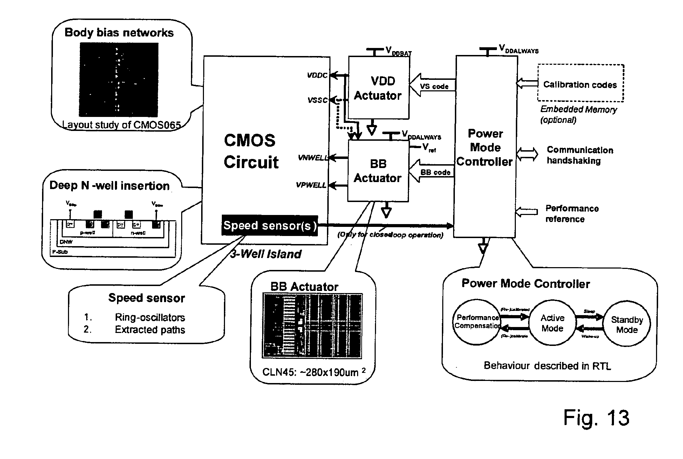

Figure 13 illustrates an embodiment of the whole hardware infrastructure for post silicon tuning, comprising a body bias actuator, a Vdd actuator, both of which are controlled by a power mode controller, and a CMOS circuit comprising body bias networks, each of which is enabled by deep n-well regions. In closed loop operation, speed sensors in each body bias network provides information to the power mode controller, which then determines the appropriate bias voltage to be applied.

This invention can be applied to integrated circuits to ensure parametric chip yield. Application of the invention can therefore effectively turn "bad" ICs, i.e. those which would otherwise fail due to out of spec performance, back into correctly functioning chips, and therefore can be used to improve yield. The invention can be also applied to chips that require extra performance without incurring a significant power penalty.

Other embodiments are within the scope of the invention, as defined by the appended claims.

### References

1. P. Pant, V.K. De, A. Chatterjee, "Simultaneous Power Supply, Threshold Voltage, and Transistor Size Optimization for Low-Power Operation of CMOS Circuits," IEEE Transactions on Very Large Scale Integration Systems, vol. 6, no. 4, pp. 538-545, December 1998.
2. Dinesh Patil, Sunghee Yun, Seung-Jean Kim, Alvin Cheung, Mark Horowitz and Stephen Boyd, "A New Method for Design of Robust Digital Circuits," Proceedings International Symposium on Quality Electronic Design (ISQED), San Jose, pp676-681, March 2005.
3. Murari Mani, Ashish K. Singh, and Michael Orshansky, "Joint Design-Time and Post-Silicon Minimization of Parametric Yield Loss using Adjustable Robust Optimization," ICCAD'06, November 5-9, 2006
4. Sarvesh H. Kulkarni, Dennis M. Sylvester, and David T. Blaauw, "Design-Time Optimization of Post-Silicon Tuned Circuits Using Adaptive Body Bias," IEEE Transactions on Very Large Scale Integration Systems, vol. 27, no. 3, March 2008.
5. Justin Gregg and Tom W. Chen, "Post Silicon Power/Performance Optimization in the Presence of Process Variations Using Individual Well-Adaptive Body Biasing," IEEE Transactions on Very Large Scale Integration Systems, vol. 15, no. 3, March 2007.
6. EP08105734.1: On-chip Circuit Component for Body Biasing in Multiple Power Domain SoCs.

## Claims

1. An integrated circuit comprising:
a plurality of n-well and p-well regions (305, 306) arranged in alternating parallel rows across a plane of the integrated circuit;
a deep n-well region (301) beneath the n-well and p-well regions (305, 306) and extending between first and second n-well region rows (305₁, 305₂) either side of a third n-well region row (305₃); and
a plurality of n-well region columns (307) connecting the first and second n-well region rows (305₁, 305₂) and overlaying a portion of a boundary of the deep n-well region (301).

2. The integrated circuit of claim 1 wherein the first and second n-well region rows (305₁, 305₂) overlay a portion of the boundary of the deep n-well region (301).

3. The integrated circuit of claim 2 wherein the entire boundary of the deep n-well region (301) is overlaid with n-well regions.

4. The integrated circuit of any preceding claim wherein one or more passive components are provided in cells (401) across the first or second n-well region row (305₁, 305₂) and an adjacent p-well region row (306₃, 306₄) outside the boundary of the deep n-well region.

5. The integrated circuit of claim 4 wherein the one or more passive components are capacitors.

6. The integrated circuit of any preceding claim comprising a plurality of said deep n-well regions (501, 502), each deep n-well region being separated from an adjacent deep n-well region by a p-well region column (503).

7. A method of manufacturing an integrated circuit, the method comprising the steps of:
defining a deep n-well region (301) in a substrate;
defining a plurality of n-well and p-well regions (305, 306) over the deep n-well region (301), the plurality of n-well and p-well regions (305, 306) being arranged in alternating parallel rows across a plane of the substrate, the deep n-well region (301) extending between first and second n-well region rows (305₁, 305₂) either side of a third n-well region row (305₃); and
defining a plurality of n-well region columns (307) connecting the first and second n-well region rows (305₁, 305₂) and overlaying a portion of a boundary of the deep n-well region (301).

8. A method of designing a layout of an integrated circuit, the method comprising:
defining a plurality of n-well and p-well regions (305, 306) arranged in alternating parallel rows across a plane of the integrated circuit;
arranging a plurality of cells comprising transistors over the plurality of n-well and p-well regions (305, 306), in which a subset of the plurality of cells is selected to require a common body bias voltage;
defining a deep n-well region (301) beneath a selected area of the n-well and p-well regions (305, 306), the deep n-well region (301) extending between first and second n-well region rows (305₁, 305₂) either side of a third n-well region row (305₃);
positioning the subset of the plurality of cells over the deep n-well region (301); and
defining a plurality of n-well region columns (307) connecting the first and second n-well region rows (305₁, 305₂) and overlaying a portion of a boundary of the deep n-well region (301).

9. The method of claim 8 wherein the subset of the plurality of cells is selected based on the longest paths (701) in the integrated circuit.

10. The method of claim 9 wherein the subset of the plurality of cells is selected from the longest 3% of paths in the integrated circuit.
